# EUROPEAN PATENT SPECIFICATION

(11) **EP 4 246 554 B1**
(45) Date of publication and mention of the grant of the patent: **10.12.2025**
(21) Application number: 23161718.4
(22) Date of filing: 14.03.2023
(51) Int. Cl.: H10D 8/01, H10D 8/60, H10D 62/10, H10D 62/832, H01L 21/04, H01L 21/20

(54) **FORMING AN ELECTRONIC DEVICE, SUCH AS A JBS OR MPS DIODE, BASED ON 3C-SIC, AND 3C-SIC ELECTRONIC DEVICE**
HERSTELLUNG EINER ELEKTRONISCHEN VORRICHTUNG, WIE EINE JBS ODER MPS DIODE, AUF BASIS VON 3C-SIC, UND 3C-SIC ELEKTRONISCHE VORRICHTUNG
FORMATION D'UN DISPOSITIF ÉLECTRONIQUE, TEL QU'UNE DIODE JBS OU MPS, BASÉ SUR UN 3C-SIC, ET DISPOSITIF ÉLECTRONIQUE 3C-SIC

(30) Priority: 18.03.2022 IT 202200005363
(43) Date of publication of application: 20.09.2023
(73) Proprietor: STMicroelectronics S.r.l., 20864 Agrate Brianza (MB) (IT)
(72) Inventor: RASCUNA', Simone, 95129 Catania (IT); ROCCAFORTE, Fabrizio, 95030 Mascalucia (CT) (IT); BELLOCCHI, Gabriele, 95124 Catania (IT); VIVONA, Marilena, 91013 Calatafimi Segesta (TP) (IT)
(74) Representative: Studio Torta S.p.A.

(56) References cited:
- US-A1- 2013 240 906
- US-A1- 2021 328 023
- INSUNG CHOI ET AL: "Laser-induced phase separation of silicon carbide", vol. 7, no. 1, 4 January 2016 (2016-01-04), pages 13562 - 1, XP009540307, ISSN: 2041-1723, Retrieved from the Internet <URL:http://www.nature.com/articles/ncomms13562> [retrieved on 20161130], DOI: 10.1038/NCOMMS13562

## Description

The present invention relates to an electronic device formed, at least in part, in 3C-SiC and to a method for manufacturing the 3C-SiC electronic device.

As is known, semiconductor materials, which have a wide bandgap, in particular, which have an energy value Eg of the bandgap greater than 1.1 eV, low on-state resistance (R_{ON}), high value of thermal conductivity, high operating frequency and high saturation velocity of charge carriers, are ideal for producing electronic components, such as diodes or transistors, in particular for power applications. A material having said characteristics, and designed to be used for manufacturing electronic components, is silicon carbide (SiC). Silicon carbide comes in different crystalline forms, also called polytypes. The most common polytypes are the cubic polytype (polytype 3C-SiC), the hexagonal polytype (polytypes 4H-SiC and 6H-SiC) and the rhombohedral polytype (polytype 15R-SiC).

Electronic devices provided on a silicon carbide substrate, as compared to similar devices provided on a silicon substrate, have numerous advantages, such as low output resistance in conduction, low leakage current, high working temperature, and high operating frequencies. In particular, SiC Schottky diodes have demonstrated higher switching performances, making SiC electronic devices particularly favorable for high frequency applications. Current applications impose requirements on electrical properties and also on long-term reliability of devices.

Owing to a greater ease of manufacturing with respect to other polytypes, 4H-SiC is commonly used as a substrate. However, the bandgap of 4H-SiC is greater (3.2 eV) with respect to the corresponding bandgap of 3C-SiC (2.3 eV) or Silicon (1.12 eV), making 4H-SiC less attractive to some electronic applications with respect to 3C-SiC or with respect to Silicon. For example, in case of Schottky barrier diodes, the possibility of controlling the Schottky Barrier Height (SBH) value is an important aspect in order to reduce energy consumption and minimize conduction losses. To this end, the implementation of metal/3C-SiC or metal/Si contacts results in lower SBH values with respect to the SBH values of metal/4H-SiC contacts, enabling the manufacturing of more efficient Schottky diodes.

Moreover, the breakdown voltage of SiC is also greater than that of Silicon. This is due to the fact that the critical electric field of SiC is about ten times greater than that of Silicon. In general, a further advantage associated with the manufacturing of a device on a substrate (bulk) of 4H-SiC is maintaining the advantage in breakdown voltage, but having on the surface a material with a lower bandgap (for example, silicon or 3C-SiC), so as to have a reduction in the barrier height, for example, of the Schottky contact. In other words, maintaining the advantage in reverse bias and optimizing the voltage drop in forward bias is desirable.

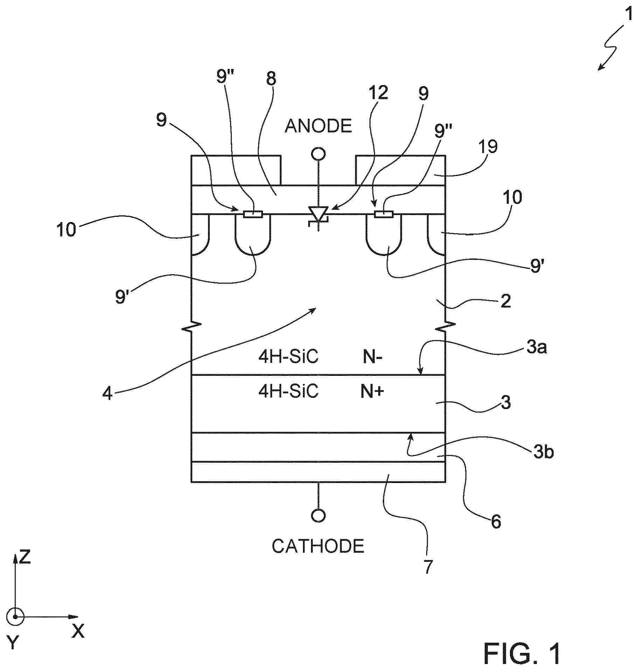

Figure 1 shows, in lateral sectional view in a Cartesian (triaxial) reference system of X, Y, Z axes, a Junction Barrier Schottky (JBS) device, or similarly a Merged-PN-Schottky (MPS) diode, identified with the reference number 1. The device of Figure 1 is not necessarily known art, and reference will be made hereinafter to a JBS device 1 without thereby losing generality.

The JBS device 1 includes: a substrate 3, of N-type doped 4H-SiC, having a first dopant concentration (e.g., comprised between 1·10¹⁹ and 1·10²² atoms/cm³), resistivity comprised, for example, between 2 mΩ·cm and 40 mΩ·cm, provided with a surface 3a opposite to a surface 3b, and a thickness comprised between 50 µm and 350 µm, more particularly between 160 µm and 200 µm, for example equal to 180 µm; a drift layer (epitaxially grown) 2, of N-type 4H-SiC, having a second dopant concentration lower than the first dopant concentration (for example comprised between 1·10¹⁴ and 5·10¹⁶ atoms/cm³), which extends on the surface 3a of the substrate 3, and a thickness comprised between 5 and 15 µm; an ohmic contact region 6 (for example of Nickel Silicide), which extends on the surface 3b of the substrate 3; a cathode metallization 7, for example of Ti/NiV/Ag or Ti/NiV/Au, which extends on the ohmic contact region 6; an anode metallization 8, for example of Ti/AlSiCu or Ni/AlSiCu, which extends on a top surface 2a of the drift layer 2; a passivation layer 19 on the anode metallization 8, to protect the latter; a plurality of Junction-Barrier (JB) elements 9 in the drift layer 2, facing the top surface 2a of the drift layer 2 and each including a respective implanted region 9' of P-type and an ohmic contact 9"; and an edge termination region, or protection ring, 10 (optional), in particular a P-type implanted region, which surrounds (completely or partially, depending on the design options) the JB elements 9.

Schottky diodes 12 are formed at the interface between the drift layer 2 and the anode metallization 8. In particular, Schottky (semiconductor-metal) junctions are formed by portions of the drift layer 2 in direct electrical contact with respective portions of the anode metallization 8.

The region of the JBS device 1 including the JB elements 9 and the Schottky diodes 12 (i.e., the region contained within the protection ring 10) is an active area 4 of the JBS device 1.

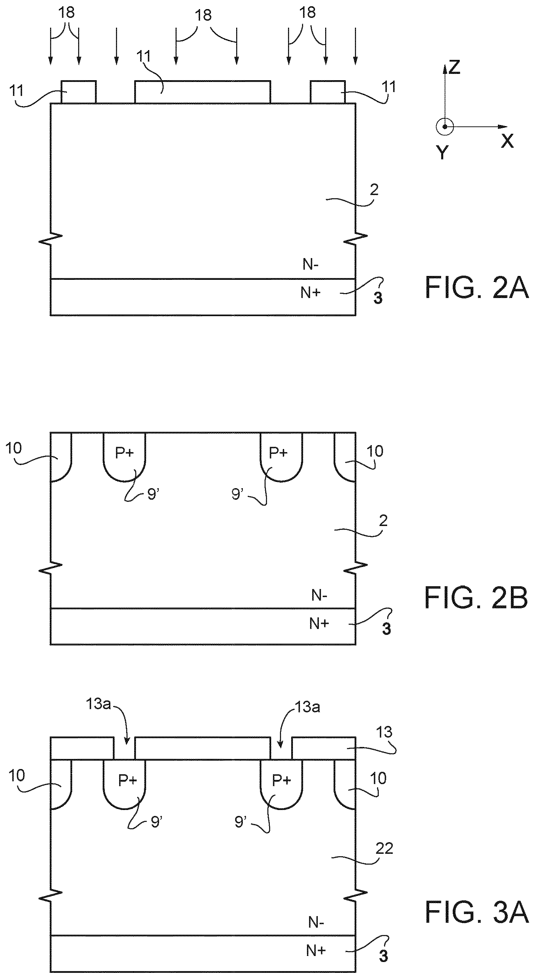

With reference to Figures 2A and 2B, the manufacturing steps of the JBS device 1 of Figure 1 provide (Figure 2A) for a step of masked implant of doping species which have the second conductivity type (P), for example boron or aluminum, in the drift layer 2. The implant is illustrated with arrows 18 in Figure 2A. A mask 11 is used for the implant, in particular a hard mask of Silicon Oxide or TEOS. In an exemplary embodiment, the implant step comprises one or more implants of doping species, which have the second conductivity type, with implant energy comprised between 30 keV and 400 keV and with doses between 1·10¹² atoms/cm² and 1·10¹⁵ atoms/cm².

Implanted regions 9' and the edge termination region 10 are thus formed. The implanted regions 9' and the edge termination region 10 have a depth, measured from the surface 2a, comprised between 0.2 µm and 1 µm.

Then, Figure 2B, the mask 11 is removed and a thermal annealing step is performed for the activation of the doping species implanted in the step of Figure 2A. The thermal annealing is, for example, performed in a furnace at a temperature higher than 1600°C (for example, between 1700 and 1900°C and in some cases even higher).

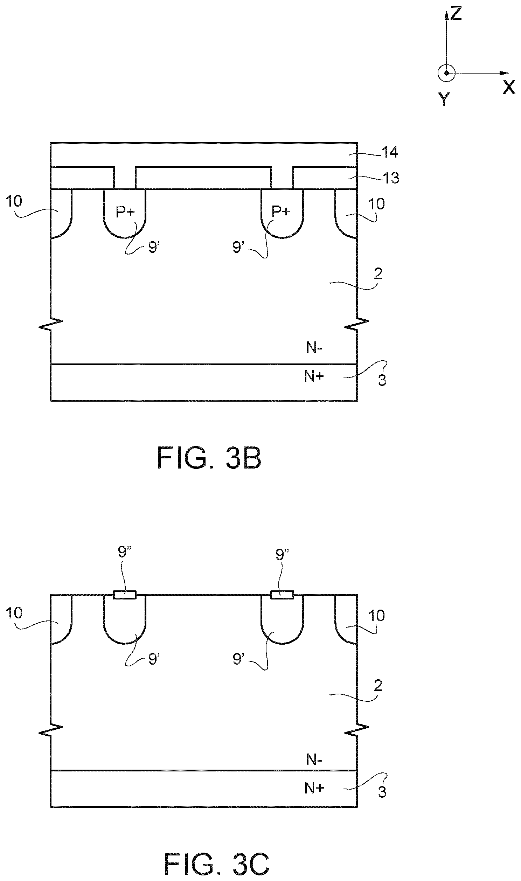

With reference to Figures 3A-3C, further steps are then performed for forming the ohmic contacts 9". With reference to Figure 3A, a deposition mask 13 of Silicon Oxide or TEOS is formed, to cover surface regions of the drift layer 2 other than the implanted regions 9' (and of the edge termination 10, if any). In other words, the mask 13 has through openings 13a at the implanted regions 9' (and optionally at at least one portion of the edge termination 10). Then, Figure 3B, a Nickel deposition is performed on the mask 13 and inside the through openings 13a (metal layer 14 in Figure 3B). The Nickel thus deposited reaches and contacts the implanted regions 9' and the edge termination region 10 through the through openings 13a.

With reference to Figure 3C, a subsequent thermal annealing at a high temperature (between 700°C and 1200°C for a time interval from 1 minute to 120 minutes), allows ohmic contacts 9" of Nickel Silicide to be formed, by chemical reaction between the deposited Nickel and the Silicon Carbide (4H-SiC) of the drift layer 2 at the through openings 13a. In fact, the deposited Nickel reacts where it is in contact with the surface material of the drift layer 2, forming Ni₂Si (i.e., the ohmic contact). Subsequently, a step of removing the metal which extends above the mask 13 and a removal of the mask 13 are performed.

After forming the ohmic contacts, the method proceeds forming (e.g., by deposition) the anode metallization 8, for example of Ti/AlSiCu or Ni/AlSiCu, on the top surface 2a of the drift layer 2 and in direct electrical contact with the ohmic contacts 9". Then, the passivation layer 19 is formed on the anode metallization 8, to protect the latter. Consequently, respective Schottky diodes 12 are formed at the interface between the drift layer 2 and the anode metallization 8, lateral to the implanted regions 9'. In particular, Schottky (semiconductor-metal) junctions are formed by portions of the drift layer 2 in direct electrical contact with respective portions of the anode metallization 8, between the JB elements 9.

Prior art devices and processes are known from US 2021/0328023 A1 and US 2013/0240906 A1.

The aim of the present invention is to provide an electronic device formed, at least in part, in 3C-SiC and a method for manufacturing the 3C-SiC electronic device, such as to overcome the drawbacks of the prior art.

According to the present invention, a method for manufacturing an electronic device and an electronic device are provided, as defined in the attached claims.

For a better understanding of the present invention, preferred embodiments thereof are now described, purely by way of non-limiting example, with reference to the attached drawings, wherein:
- Figure 1 shows, in cross-sectional view, a JBS or MPS device according to an embodiment which is not an object of the present invention;
- Figures 2A and 2B show, in cross-sectional view, intermediate manufacturing steps of the device of Figure 1, according to an embodiment which is not an object of the present invention;

- Figures 3A-3C show, in cross-sectional view, steps for forming ohmic contacts of the device of Figure 1, subsequently to the steps of Figures 2A and 2B, according to an embodiment which is not an object of the present invention;
- Figure 4 shows, in cross-sectional view, a JBS or MPS device according to an embodiment not in accordance with the present invention;
- Figures 5A and 5B show, in cross-sectional view, intermediate manufacturing steps of the device of Figure 4, according to an embodiment not in accordance with the present invention;
- Figures 6A-6D show, in cross-sectional view, intermediate manufacturing steps of the device of Figure 4, according to a further embodiment not in accordance with the present invention, alternative to the embodiment of Figures 6A-6B;
- Figure 7 shows, in cross-sectional view, a JBS or MPS device according to a further embodiment not in accordance with the present invention;
- Figures 8A-8C show, in cross-sectional view, intermediate manufacturing steps of the device of Figure 7, according to an embodiment not in accordance with the present invention;
- Figure 9 shows, in cross-sectional view, a JBS or MPS device according to an embodiment of the present invention;
- Figures 10A-10D show, in cross-sectional view, intermediate manufacturing steps of the device of Figure 9, according to an embodiment of the present invention; and
- Figure 11 shows, in cross-sectional view, a planar MOSFET device according to a further embodiment of the present invention.

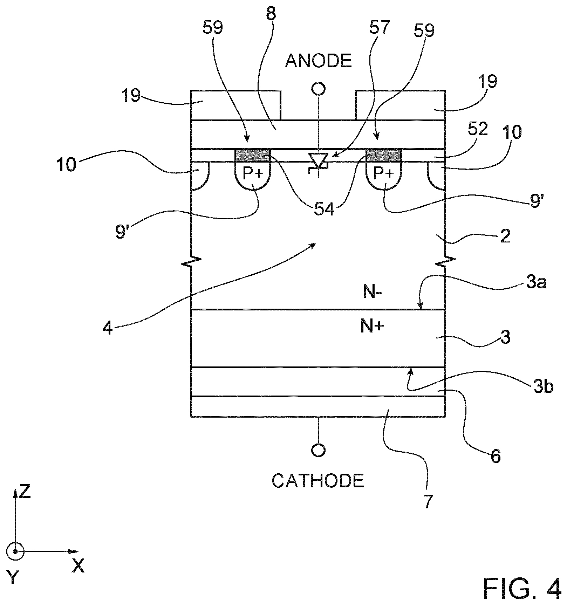

Figure 4 shows, in lateral sectional view in the Cartesian (triaxial) reference system of X, Y, Z axes of Figure 1, a JBS device 50, according to an embodiment not in accordance with the present invention. The view of Figure 4 may similarly relate to an MPS device (diode) (hereinafter reference will be made exclusively to a JBS device without thereby losing generality).

Elements common to the JBS device 1 of Figure 1 are identified with the same reference numbers and are not necessarily further described.

The JBS device 50 includes: the substrate 3, of N-type 4H-SiC, having the first dopant concentration; the (epitaxial) drift layer 2, of N-type 4H-SiC, having the second dopant concentration; a cubic silicon carbide (3C-SiC) layer 52 on the surface 2a; the anode metallization 8, for example of Ti/AlSiCu or Ni/AlSiCu, which extends on the 3C-SiC layer 52; the passivation layer 19 on the anode metallization 8; the plurality of implanted regions 9' in the drift layer 2, facing the top surface 2a of the drift layer 2, at the interface with the 3C-SiC layer 52; a plurality of ohmic contacts 54, extending through the 3C-SiC layer at respective implanted regions 9' and forming, with the latter, respective JB elements 59; the edge termination region, or protection ring, 10 (optional), in particular a P-type implanted region, which completely or partially surrounds the JB elements 9; the ohmic contact region, or layer, 6 (for example of Nickel Silicide), which extends on the surface 3b of the substrate 3; the cathode metallization 7, for example of Ti/NiV/Ag or Ti/NiV/Au, which extends on the ohmic contact region 6.

One or more Schottky diodes 57 extend at the interface between the 3C-SiC layer 52 and the anode metallization 8, lateral to the implanted regions 9'. In particular, one or more Schottky (semiconductor-metal) junctions are formed by portions of the 3C-SiC layer 52 in direct electrical contact with respective portions of the anode metallization 8.

The region of the JBS device 50 which includes the JB elements 59 and the Schottky diodes 57 (i.e., the region contained within the protection ring 10, if any) is the active area 4 of the JBS device 50.

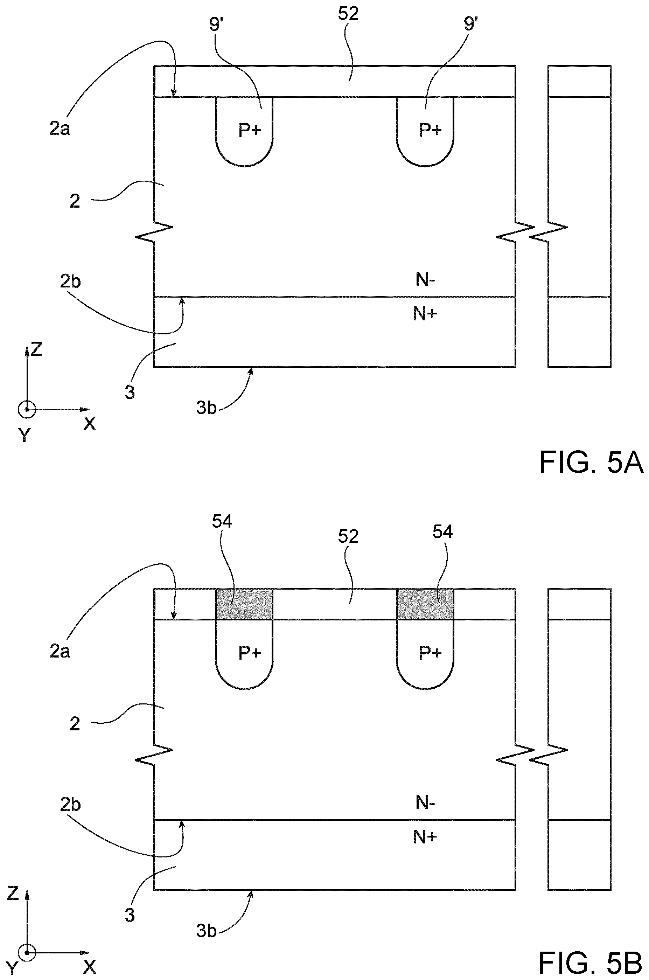

Figures 5A and 5B show, in lateral sectional view in the Cartesian (triaxial) reference system of X, Y, Z axes of Figures 2A-2B, 3A-3C and 4, intermediate manufacturing steps of the JBS device 50, according to an embodiment not in accordance with the present invention.

In particular, after performing the steps of Figures 2A and 2B (not further described herein), a step of forming (e.g., growing) a cubic silicon carbide (3C-SiC) layer 52 on the surface 2a of the drift layer 2 is performed, as illustrated in Figure 5A.

The growth of 3C-SiC on a 4H-SiC substrate/layer is known per se. A method for this purpose is known as the Vapor-Liquid-Solid (VLS) mechanism, for example described by Soueidan M. et al., "A Vapor-Liquid-Solid Mechanism for Growing 3C-SiC Single-Domain Layers on 6H-SiC (0001) ", Advanced Functional Materials, vol. 16, pages 975-979, 02 May 2006.

Another method is known as Sublimation Epitaxy (SE), for example described by Valdas Jokubavicius et al., "Lateral Enlargement Growth Mechanism of 3C-SiC on Off-Oriented 4H-SiC Substrates", Crystal Growth & Design 2014 14 (12), 6514-6520.

Another method is known from Rositsa Yakimova et al., "Growth, Defects and Doping of 3C-SiC on Hexagonal Polytypes", ECS Journal of Solid State Science and Technology, Volume 6, Number 10, p. 741, November 2017.

Then, the method proceeds, Figure 5B, with a step of forming the ohmic contacts 54, exploiting the process already described with reference to Figures 3A-3C, adapted to the embodiment of Figure 5B. In particular, in this case, the mask 13 is formed on the 3C-SiC layer 52 and the through openings 13a extend up to reaching the 3C-SiC layer 52. Therefore, the metal layer 14 extends up to reaching the 3C-SiC layer 52.

The formation of the ohmic contacts involves a deposition of Nickel within the openings 13a. The Nickel thus deposited reaches and contacts the 3C-SiC 52 layer. Subsequent high-temperature heat treatment (between 700°C and 1200°C for a time interval of 1 minute to 120 minutes), allows for the formation of Nickel Silicide ohmic contacts 54 by chemical reaction between the deposited Nickel and Silicon Carbide (3C-SiC) at the openings 13a.

Alternatively, it is possible to form openings 13a that extend up to drift layer 2 at the implanted regions 9'. The formation of the ohmic contacts in this case involves the deposition of Nickel within the openings 13a until it reaches the implanted regions 9'.

After the step of Figure 5B, the method proceeds with steps of forming (e.g., by deposition) the anode metallization 8, for example of Ti/AlSiCu or Ni/AlSiCu, on the 3C-SiC layer 52, in direct electrical contact with the ohmic contacts 54. Then, the passivation layer 19 is formed on the anode metallization 8, to protect the latter. Consequently, respective Schottky diodes 57 are formed at the interface between the 3C-SiC layer 52 and the anode metallization 8, lateral to the ohmic contacts 57.

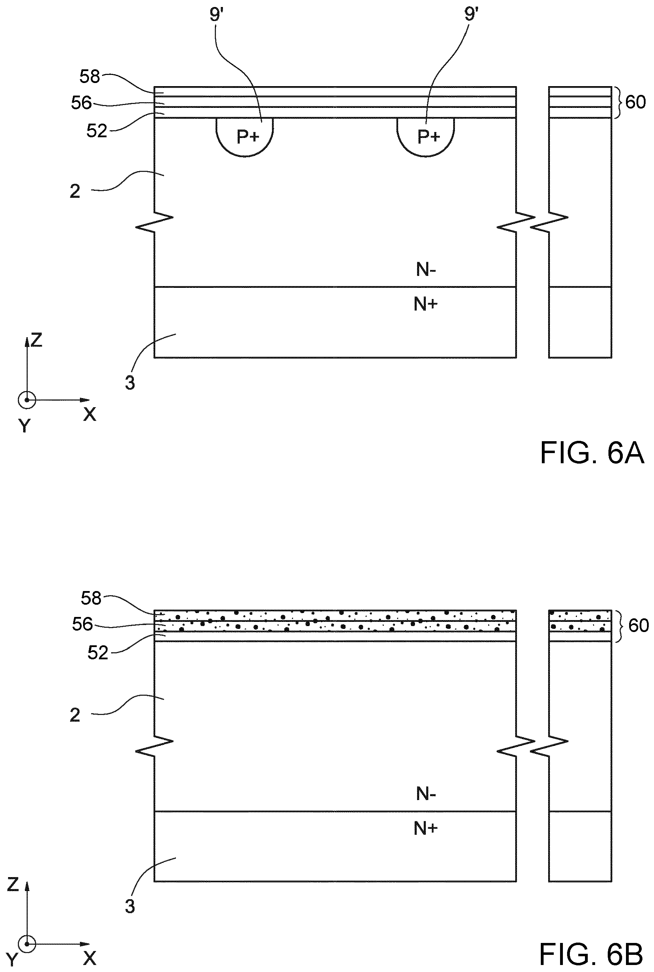

Figures 6A-6D illustrate a further method for forming the 3C-SiC layer 52 not in accordance with the present invention.

In this case, the step of forming the cubic silicon carbide (3C-SiC) layer 52 on the surface 2a of the drift layer 2 may occur by melting and resolidification (crystallization) of the 4H-SiC material of the drift layer 2, for example as described by Choi, I., Jeong, H., Shin, H. et al., "Laser-induced phase separation of silicon carbide", Nature Communications 7, 13562 (2016).

As illustrated in Figure 6A, this process leads to the formation of a stack 60 including: the 3C-SiC layer 52 on the drift layer 2 of 4H-SiC; a Silicon layer 56 on the 3C-SiC layer 52; and a Carbon-rich layer 58 (for example of Graphite or including Graphite or including Graphite layer(s), or of Graphene, or including Graphene, or including Graphite and Graphene) on the Silicon layer 56. In one embodiment, the 3C-SiC layer 52 has a thickness comprised between 10 and 200 nm, the Silicon layer 56 has a thickness comprised between 5 and 100 nm and the carbon-rich layer has a thickness comprised between 5 and 100 nm.

Since this process entails a crystallographic change of a portion of the drift layer 2 at the top surface 2a, after the formation of the stack 60 the drift layer 2 has a reduced thickness. The Applicant has verified that this melting and crystallization step does not damage the implanted regions 9' from an electrical or functional point of view.

The 3C-SiC layer 52 and the Silicon layer 56 have substantially the same doping as the drift layer 2 of 4H-SiC, since the melting and crystallization step does not entail a modification of the dose of dopants already present in the drift layer 2.

The melting of the 4H-SiC material of the drift layer 2 is performed, in particular, through LASER, whose configuration and operating parameters are the following:
wavelength between 240 and 700 nm, in particular 308 nm;
pulse duration between 20 ns and 500 ns, in particular 160 ns;
number of pulses between 1 and 16, in particular 4;
energy density between 1.6 and 4 J/cm², in particular 2.6 J/cm², (considered at the level of the top surface 2a);
temperature between 1400 °C and 2600 °C, in particular 2200 °C (considered at the level of the surface 2a).

The area of the spot of the beam 102 at the level of the front side 2a is, for example, comprised between 0.7 and 1.5 cm².

After the melting step, the crystallization of the portion(s) being melted occurs at a temperature comprised between 1600 and 2600 °C for a time comprised between 200 and 600 ns. The stack 60, previously described, is thus formed.

Then, Figure 6B, an oxidation step of the Carbon-rich layer 58 and of the underlying Silicon layer 56 is performed, forming respective oxidized layers. This step is performed by inserting the wafer into a furnace at a temperature of 800 °C for 60 min. This favors the oxidation of both the Carbon-rich layer 58 and the Silicon layer 56. The Applicant has not observed a corresponding oxidation of the 3C-SiC layer 52 and of the 4H-SiC material of the substrate 3 and of the epitaxial layer 2.

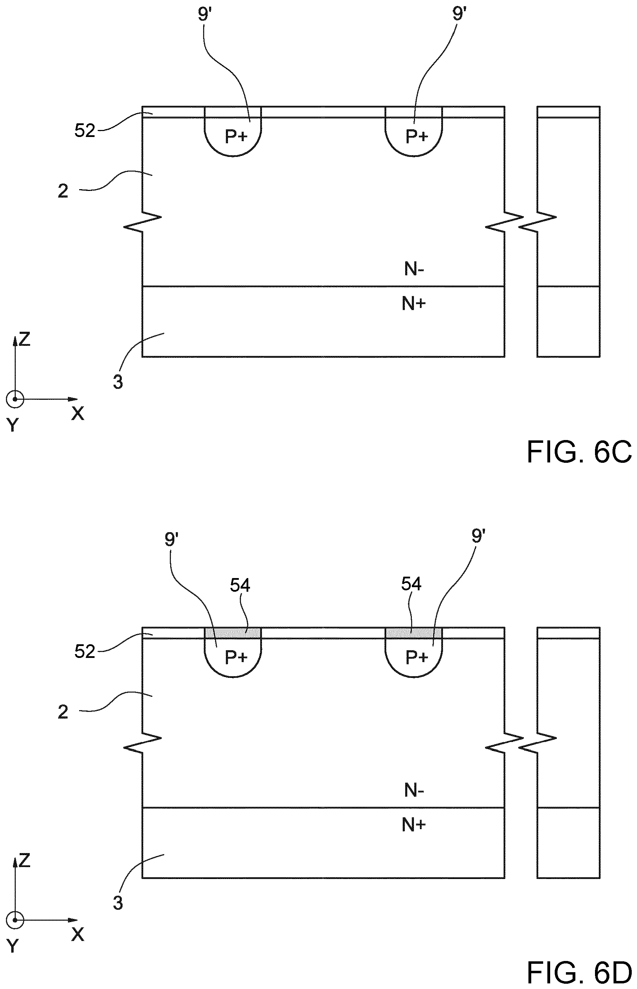

Then, Figure 6C, a subsequent bath in a suitable wet etching solution, such as for example BOE (Buffered Oxide Etchant), allows the complete removal of the oxidized layers in the step of Figure 6B, exposing the 3C-SiC layer 52. Since the etching chemical solution selectively removes the material of the layers 56, 58 that have been oxidized, the etching proceeds until such oxidized layers are completely removed, without removing the underlying 3C-SiC layer 52.

Then, Figure 6D, the ohmic contacts 54 are formed through the 3C-SiC layer 52, at the implanted regions 9' (and possibly at the protection ring 10, if any), according to what has already been described with reference to Figure 5B (that is, following the process of Figures 3A-3C, with the suitable modifications already discussed).

The Applicant has verified that by using a suitably configured LASER source, it is possible to simultaneously melt the surface portion of the drift layer 2 (with the aim of forming the 3C-SiC layer 52 as described above) and activate the doping species of the implanted regions 9'. The relevant LASER configuration parameters are the following:
- energy density equal to, or greater than, 2.4 J/cm² (considered at the level of the top surface 2a),
- number of pulses comprised between 1 and 16, for example equal to 4,
- time duration of each pulse comprised between 20 and 500 ns, for example equal to 160ns,
- wavelength of the emitted radiation comprised between 240 and 700, for example equal to 308 nm.

In this embodiment, the step of activating the dopants in the furnace described with reference to Figure 2B, may be omitted.

After the step of Figure 6D, the method proceeds with steps of forming (e.g., by deposition) the anode metallization 8, for example of Ti/AlSiCu or Ni/AlSiCu, on the 3C-SiC layer 52, in direct electrical contact with the ohmic contacts 54. Then, the passivation layer 19 is formed on the anode metallization 8, to protect the latter. Consequently, respective Schottky diodes 57 are formed at the interface between the 3C-SiC layer 52 and the anode metallization 8, lateral to the ohmic contacts 57.

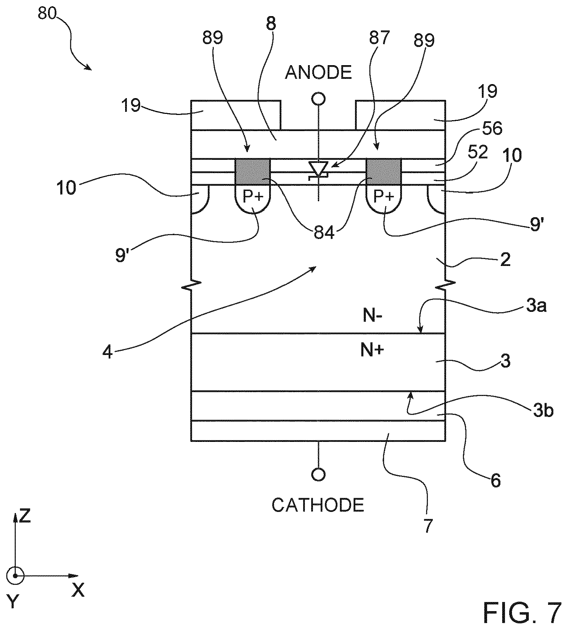

Figure 7 shows, in lateral sectional view in the Cartesian (triaxial) reference system of X, Y, Z axes of Figure 1 and Figure 4, a JBS device 80, according to an embodiment not in accordance with the present invention.

Elements common to the JBS device 1 of Figure 1 or to the JBS device 50 of Figure 4 are identified with the same reference numbers and are not necessarily described again.

The JBS device 80 includes: the substrate 3, of N-type 4H-SiC, having the first dopant concentration; the (epitaxial) drift layer 2, of N-type 4H-SiC, having the second dopant concentration; the cubic silicon carbide (3C-SiC) layer 52 on the surface 2a; the Silicon layer 56 on the 3C-SiC layer 52; the anode metallization 8, for example of Ti/AlSiCu or Ni/AlSiCu, which extends on the Silicon layer 56; the passivation layer 19 on the anode metallization 8; the plurality of implanted regions 9' in the drift layer 2, facing the top surface 2a of the drift layer 2, at the interface with the 3C-SiC layer 52; a plurality of ohmic contacts 84, extending through the 3C-SiC layer 52 and through the Silicon layer 56 at respective implanted regions 9' and forming, with the latter, respective JB elements 89; the edge termination region, or protection ring, 10 (optional), in particular a P-type implanted region, which completely or partially surrounds the JB elements 9; the ohmic contact region, or layer 6 (for example of Nickel Silicide), which extends on the surface 3b of the substrate 3; the cathode metallization 7, for example of Ti/NiV/Ag or Ti/NiV/Au, which extends on the ohmic contact region 6.

One or more Schottky diodes 87 extend at the interface between the Silicon layer 56 and the anode metallization 8, lateral to the implanted regions 9'. In particular, one or more Schottky (semiconductor-metal) junctions are formed by portions of the Silicon layer 56 in direct electrical contact with respective portions of the anode metallization 8.

The region of the JBS device 80 which includes the JB elements 89 and the Schottky diodes 87 (i.e., the region contained within the protection ring 10, if any) is the active area 4 of the JBS device 80.

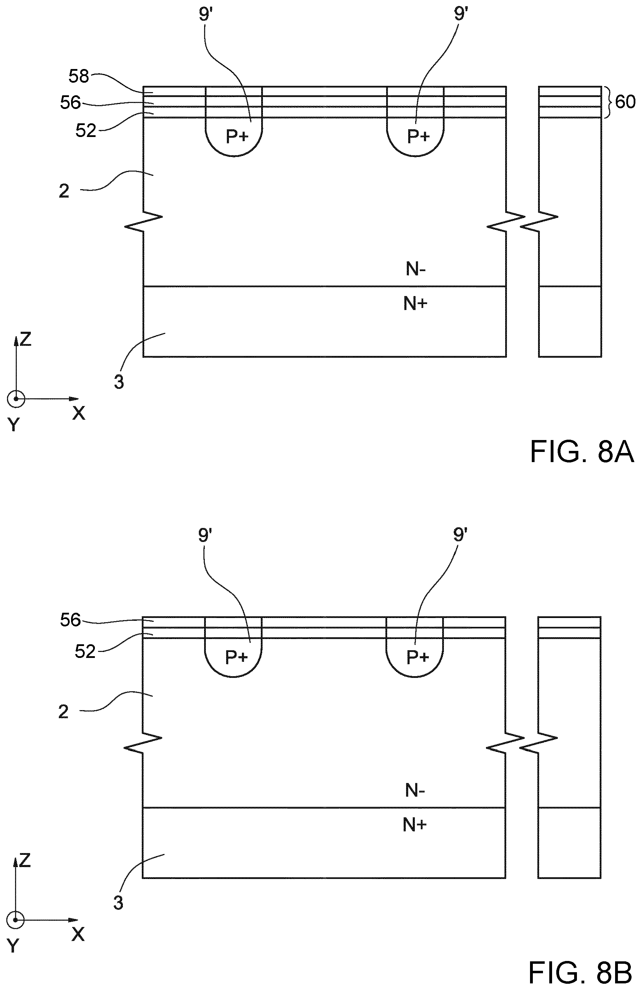

Figures 8A-8C show, in lateral sectional view in the Cartesian (triaxial) reference system of X, Y, Z axes, intermediate manufacturing steps of the JBS device 80, according to an embodiment not in with the present invention.

In this case, the steps of forming the cubic silicon carbide (3C-SiC) layer 52 and the Silicon layer 56 occur by melting and resolidification (crystallization) of the 4H-SiC material of the drift layer 2, as already discussed with reference to Figures 5A-5D.

As illustrated in Figure 8A (which corresponds to Figure 5A), initially this process leads to the formation of the same stack already described for Figure 6A, i.e. including the 3C-SiC layer 52 on the drift layer 2 of 4H-SiC, the Silicon layer 56 on the 3C-SiC layer 52, and the Carbon-rich (for example of Graphite or including Graphite or including Graphite layer(s) or of Graphene, or including Graphene, or including Graphite and Graphene) layer 58 on the Silicon layer 56.

Then, Figure 8B, a step of selectively removing the Carbon-rich layer 58, but not the underlying Silicon layer 56, is performed. This step is performed for example by plasma etching process in O₂ environment. Other chemistries or methods for selectively removing graphite / graphene may be used.

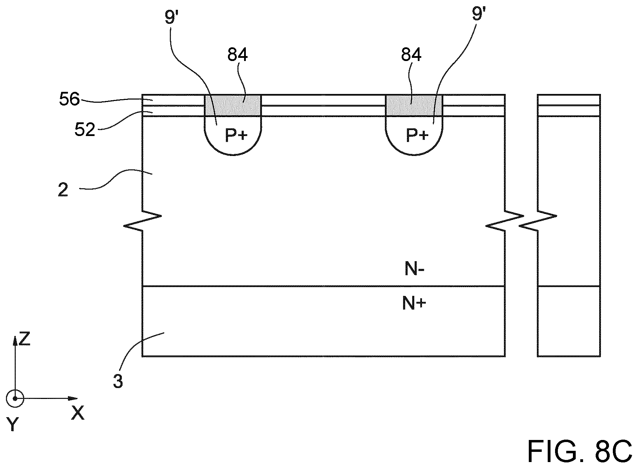

Then, Figure 8C, the ohmic contacts 84 are formed through the Silicon layer 56 and the 3C-SiC layer 52, at the implanted regions 9' (and possibly at the protection ring 10, if any). To this end, the process already described with reference to Figures 3A-3C is used, suitably modified to adapt it to the case discussed herein. In particular, in this case, the mask 13 is formed on the Silicon layer 56 and the through openings 13a extend up to reaching the Silicon layer 56. Therefore, the metal layer 14 extends up to reaching the Silicon layer 56.

The formation of the ohmic contacts involves a deposition of Nickel within the openings 13a. Subsequent high-temperature heat treatment (between 700°C and 1200°C for a time interval of 1 minute to 120 minutes), allows the formation of ohmic contacts 84 of Nickel Silicide, by chemical reaction between the deposited Nickel and Silicon in layer 52 at the openings 13a.

In an alternative form of realization, the openings 13a extend up to either the 3C-SiC 52 layer or the drift layer 2 at the implanted regions 9'. The formation of the ohmic contacts involves a deposition of Nickel within these openings 13a.

The Applicant has verified that by using a suitably configured LASER source, it is possible to simultaneously melt the surface portion of the drift layer 2 (with the aim of forming the 3C-SiC layer 52 and the Silicon layer 56 as described above) and activate the doping species of the implanted regions 9'. The relevant LASER configuration parameters are the following:
- energy density equal to, or greater than, 2.4 J/cm² (considered at the level of the top surface 2a),
- number of pulses comprised between 1 and 16, for example equal to 4,
- time duration of each pulse comprised between 20 and 500 ns, for example equal to 160 ns,
- wavelength of the emitted radiation comprised between 240 and 700, for example equal to 308 nm.

In this embodiment, the step of activating the dopants in a furnace described with reference to Figure 2B, may be omitted.

After the step of Figure 8C, the method proceeds with steps of forming (e.g., by deposition) the anode metallization 8, for example of Ti/AlSiCu or Ni/AlSiCu, on the Silicon layer 56, in direct electrical contact with the ohmic contacts 84. Then, the passivation layer 19 is formed on the anode metallization 8, to protect the latter. Consequently, respective Schottky diodes 87 are formed at the interface between the Silicon layer 56 and the anode metallization 8, lateral to the ohmic contacts 84.

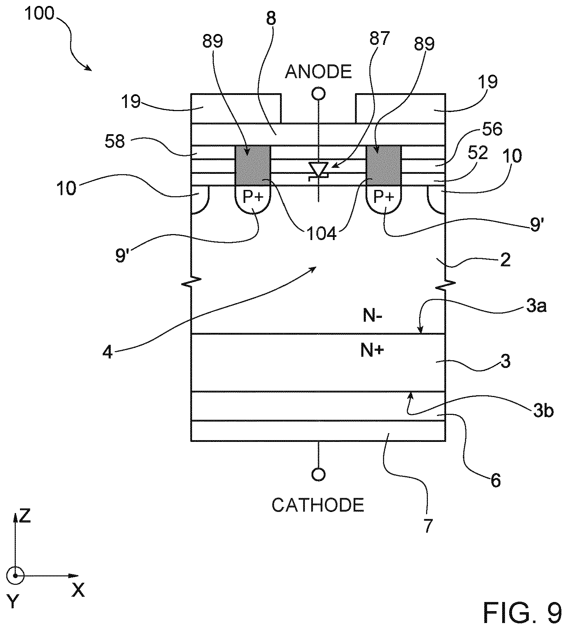

Figure 9 shows, in a lateral section view in the Cartesian (triaxial) X, Y, Z reference system of figure 7, an electronic device (in particular, JBS) 100 device, according to an embodiment of the present invention.

Common elements with the JBS 80 device in figure 7 are identified by the same reference numbers and are not necessarily described in detail again.

The JBS device 100 includes: the substrate 3, of N-type 4H-SiC, having the first dopant concentration; the drift (epitaxial) layer 2, of N-type 4H-SiC, having the second dopant concentration; the cubic silicon carbide (3C-SiC) layer 52 on the surface 2a; the Silicon layer 56 on the 3C-SiC layer 52; the Carbon-rich layer 58 on the Silicon layer 56; the anode metallization 8, e.g., of Ti/AlSiCu or Ni/AlSiCu, extending on the Carbon-rich layer 58; the passivation layer 19 on the anode metallization 8; the plurality of implanted regions 9' in the drift layer 2, facing the top surface 2a of the drift layer 2, at the interface with the 3C-SiC layer 52; a plurality of ohmic contacts 104, extending through the 3C-SiC layer 52, the Silicon layer 56 and the Carbon-rich layer 58 at respective implanted regions 9' and forming, with the latter, respective JB elements 89; the edge-terminating region, or protective ring, 10 (optional), specifically a P-type implanted region, completely or partially surrounding JB elements 9; the ohmic contact region, or layer, 6 (e.g., of Nickel Silicide), extending over surface 3b of substrate 3; the cathode metallization 7, e.g., of Ti/NiV/Ag or Ti/NiV/Au, extending over ohmic contact region 6.

One or more Schottky 87 diodes extend at the interface between the Carbon-rich layer 58 and the anode metallization 8, lateral to the implanted regions 9'. Specifically, one or more Schottky (semiconductor-metal) junctions are formed by portions of the Carbon-rich layer 58 in direct electrical contact with respective portions of the anode metallization 8. It is noted that the 3C-SiC 52 and Silicon 56 layers, and also the Carbon-rich layer 58, have the doping of the drift 2 layer from which they are formed (N-type) and therefore are electrically conductive.

The region of the JBS device 100 that includes the JB elements 89 and the Schottky diodes 87 (i.e., the region contained within the protective ring 10, when present) is the active area 4 of the JBS device 100.

The presence of the Carbon-rich layer 58 between metallization 8 and Silicon layer 56 has the function of preventing a diffusion of metal ions or metal contaminants from metallization 8 to Silicon layer 56 and, from the latter, to 3C-SiC layer 52 and, therefore, to drift layer 2.

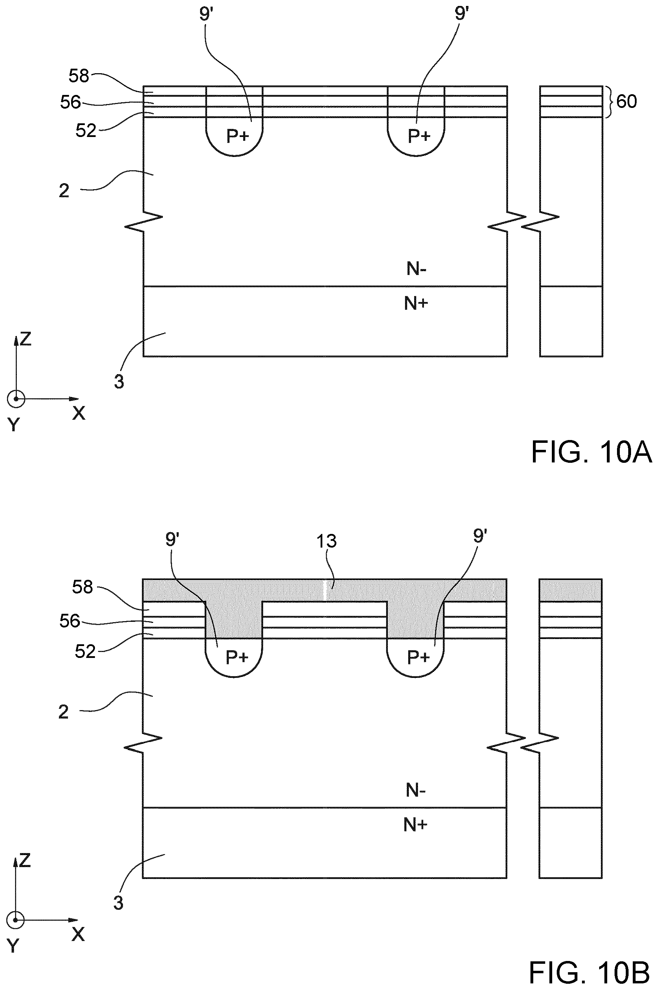

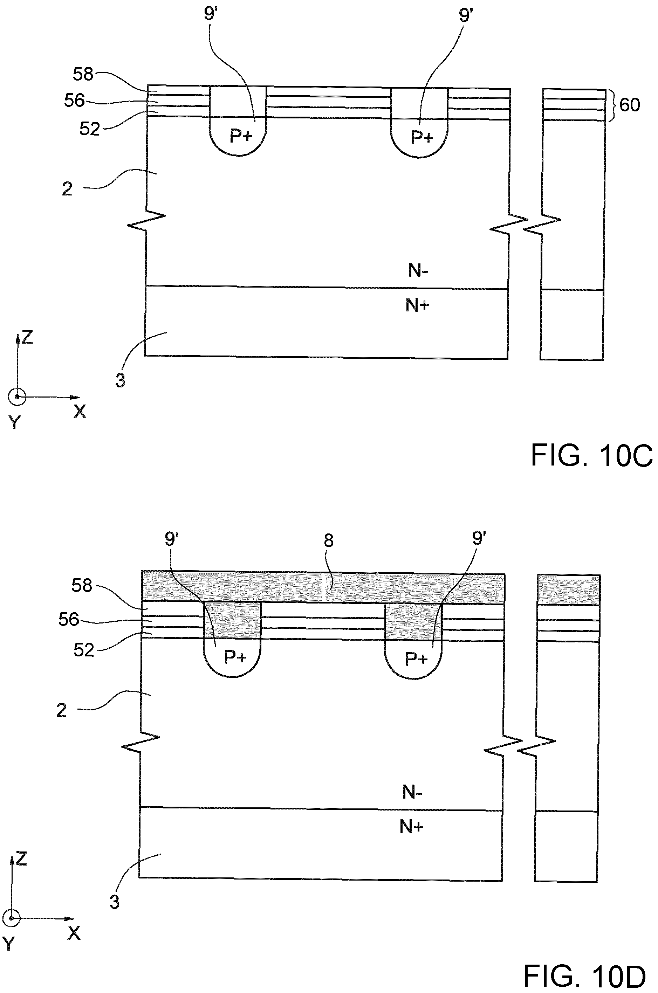

Figures 10A-10D show, in lateral section view in the Cartesian (triaxial) reference system of axes X,Y,Z, intermediate steps of fabrication of the JBS device 100, according to an embodiment of the present invention.

In this case, the formation steps of the cubic silicon carbide (3C-SiC) layer 52, the Silicon layer 56 and the Carbon-rich layer 58 occur by melting and resolidification (crystallization) of the 4H-SiC material of the drift layer 2, as discussed above with reference to Figures 5A-5D and Figure 8A.

As illustrated in Figure 10A (which corresponds to Figure 5A and Figure 8A), initially this process leads to the formation of the stack ("stack") previously described, i.e., including the 3C-SiC layer 52 on the 4H-SiC drift layer 2, the Silicon layer 56 on the 3C-SiC layer 52, and the Carbon-rich layer 58 (e.g., of Graphite or including Graphite or including Graphite layer(s) or including Graphene or including Graphite and Graphene) on the Silicon 56 layer.

Then, Figure 10B, the ohmic contacts 104 are formed across the Carbon-rich layer 58, the Silicon layer 56, and the 3C-SiC layer 52, at the implanted regions 9' (and the protective ring 10, if present). The process already described with reference to Figures 3A-3C is used for this purpose, suitably modified to adapt it to the case discussed here. Specifically, in this case, the mask 13 is formed on the Carbon-rich layer 58 and the through openings 13a extend to expose the Carbon-rich layer 58.

The formation of the ohmic contacts involves a deposition of Nickel within the through-openings 13a. Referring to Figure 10C, a subsequent high-temperature heat treatment (between 700°C and 1200°C for a time interval of 1 minute to 120 minutes) allows the formation of Nickel silicide ohmic contacts 104 by chemical reaction between the deposited Nickel and the Silicon present in layer 58.

Alternatively, the through-openings 13a extend through the Carbon-rich layer 58, until they reach the Silicon layer 56; alternatively, the through-openings 13a extend through the Carbon-rich layer 58 and the Silicon layer 56, until they reach the 3C-SiC layer 52; alternatively, the through-openings 13a extend through the Carbon-rich layer 58, the Silicon layer 56, and the 3C-SiC layer 52, until they reach the implanted regions 9' in the drift layer 2. In all these possible embodiments, the Nickel deposited in the through-openings 13a, following high-temperature heat treatment (between 700°C and 1200°C for a time interval of 1 minute to 120 minutes), forms the ohmic contacts 104 of Nickel Silicide by chemical reaction between the deposited Nickel and the Silicon present in layers 56, 52, 2 (depending on the respective embodiments).

The Applicant has verified that by using a properly configured LASER source, it is possible to simultaneously melt the surface portion of the drift layer 2 (with the purpose of forming the 3C-SiC layer 52, the Silicon layer 56, and the Carbon-rich layer 58, as described above) and activate the dopant species of the implanted regions 9'. The relevant LASER configuration parameters are as follows:
- energy density of, or greater than, 2.4 J/cm2 (considered at the level of the upper surface 2a),
- number of pulses between 1 and 16, e.g., equal to 4,
- time duration of each pulse between 20 and 500 ns, e.g. equal to 160 ns,
- wavelength of the emitted radiation between 240 and 700 nm, e.g. equal to 308 nm.

In this embodiment, the furnace dopant activation step described with reference to Figure 2B can be omitted.

After the step in Figure 10B, steps of forming (e.g., by deposition) the anode metallization 8, for example made of Ti/AlSiCu or Ni/AlSiCu, are carried out; the anode metallization 8 is formed on the Carbon-rich layer 58 and in direct electrical contact with the ohmic contacts 104. Then, the passivation layer 19 is formed on the anode metallization 8, protecting the latter. Consequently, respective Schottky diodes 87 are formed at the interface between the Carbon-rich layer 58 and the anode metallization 8, laterally to the ohmic contacts 104. This results in the device 100 of Figure 9.

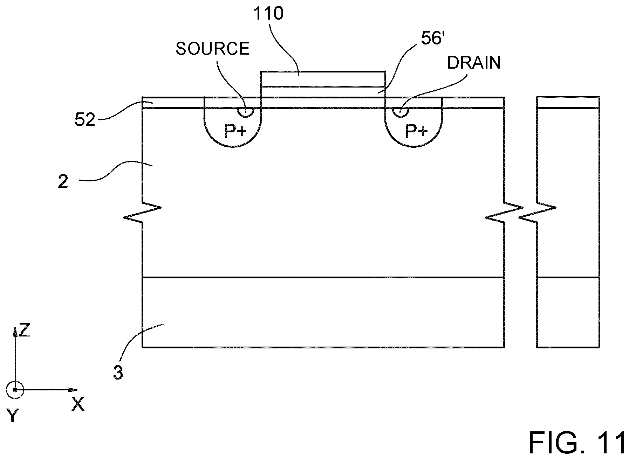

According to a further embodiment, shown in figure 11, the formation of the stack of layers of 3C-SiC 52, Silicon 56 and Carbon-rich 58 can be used to fabricate a gate terminal of a transistor (e.g., MOSFET).

For this purpose, after forming the stack of laters 3C-SiC 52, Silicon 56, and Carbon-rich 58, a step is carried out of removing the Carbon-rich layer 58 at least at selective regions of the electronic device where the gate terminal is to be formed. For example, the Carbon-rich layer 58 is removed in the area between the two implanted regions 9', exposing the underlying Silicon layer 56.

A step is then carried out to oxidize the portions of the Silicon layer 56 thus exposed, forming Silicon Oxide (SiO₂), that is the portion 56' shown in figure 11.

In one alternative embodiment, the Carbon-rich layer 58 is completely removed and the Silicon layer 56 is shaped, for example through a photolithographic process, in such a way that the Silicon layer 56 is preserved only between the two implanted regions 9'. The Silicon layer 56 between the two implanted regions 9' is then oxidized, forming portion 56' .

The 3C-SiC layer 52 can also be removed laterally to the portion 56', and is maintained below the portion 56'.

The oxidized portion 56' of the Silicon layer 56 has the function of a gate oxide. The oxidized portion 56' extends, in a top-view on plane XY, between the two implanted regions 9', optionally partially overlapping part of the two implanted regions 9'.

Thus, a metal layer is formed above the oxidized portion 56', with the function of gate metallization 110.

Source and drain regions of the MOSFET can be formed in a manner per se evident to the skilled person, by N-type implants within the P-type implanted regions 9'.

During use, the 3C-SiC layer 52 below the oxide portion 56' can participate in the formation of the conductive channel.

From an examination of the characteristics of the invention provided according to the present description, the advantages that it affords are evident.

In particular, it is possible to take full advantage of the advantages of a 4H-SiC substrate in combination with the advantages resulting from the reduced bandgap value of 3C-SiC or Silicon (in the respective embodiments) for the formation of the JB elements and the Schottky contacts, as previously discussed.

Finally, it is clear that modifications and variations may be made to what has been described and illustrated herein, without thereby departing from the scope of the present invention, as defined in the attached claims.

The present invention is not limited to the manufacturing of 3C-SiC JBS devices, but extends to the formation of ohmic contacts in generic electronic devices, such as for example a MOSFET (in particular a vertical channel MOSFET), an IGBT, a JFET, a DMOS, a Merged-PN-Schottky (MPS) diode, etc. Forming the channel of a vertical MOSFET in a 3C-SiC layer (instead of in other SiC polytypes, such as 4H-SiC) brings a considerable advantage in terms of output resistance of the device, due to the different electron mobility between 3C-SiC and 4H-SiC.

## Claims

1. A method for manufacturing an electronic device (50; 80), comprising the steps of:
- forming, at a front side (2a) of a solid body (3, 2) of 4H-SiC having a first electrical conductivity (N), at least one implanted region (9') having a second electrical conductivity (P) opposite to the first electrical conductivity (N);
- heating, through a LASER beam, at least one portion of the front side (2a) of the solid body (3, 2), at least up to a melting temperature of the 4H-SiC material;
- allowing the cooling and crystallization of the melted portion of the solid body (3, 2), forming a stack of superimposed layers including: a 3C-SiC layer (52) in contact with the solid body (3, 2), a Silicon layer (56) on the 3C-SiC layer (52), and a Carbon-rich layer (58) on the Silicon layer (56), the Carbon-rich layer (58) being of graphite or including: Graphite, or one or more Graphite layers, or Graphene, or Graphite and Graphene;
- forming a ohmic contact region (84; 104) through said stack, up to reaching the implanted region (9'); and
- forming a first electrical terminal (8) of conductive material above, and in direct contact with, the Carbon-rich layer (58).

2. The method according to claim 1, wherein said step of forming the first electrical terminal (8) includes depositing metallic material above and in direct contact with the Carbon-rich layer (58) and the ohmic contact region (84; 104).

3. The method according to claim 1 or 2, wherein forming the first electrical terminal (8) includes simultaneously forming a Schottky diode (57; 87) between the first electrical terminal (8) and the Carbon-rich layer (58), and a junction barrier diode (59; 89) between the first electrical terminal (8) and the ohmic contact region (54; 84).

4. The method according to claim 3, wherein the first electrical terminal (8) is common to said junction barrier diode and Schottky diode,
the method further comprising the step of forming, at a back side (3b) opposite the front side (2a) of the solid body, a second electrical terminal (7) common to said junction barrier diode and Schottky diode.

5. Method according to claim 1, further comprising the steps of:
- removing selective portions of the Carbon-rich layer (58) extending laterally to the implanted region (9'), exposing respective portions of the underlying Silicon layer (56) ;
- carrying out an oxidation step of the exposed portions of the Silicon layer (56), forming oxidized portions (56'); and
- forming a metallization above, and in contact with, the oxidized portions of the Silicon (56) layer.

6. The method according to claim 5, wherein said oxidized portions (56') of the Silicon layer (56) and said metallization form a gate terminal of the electronic device.

7. The method according to claim 5 or 6, further comprising the step of forming, at the front side (2a) of the solid body (3, 2), an additional implanted region (9') having the second electrical conductivity (P), said additional implanted region (9') extending at a distance from the implanted region (9'),
wherein said selective portions of the Carbon-rich layer (58) that are removed extend between the implanted region (9') and the additional implanted region (9'),
and wherein one between the implanted region (9') and the additional implanted region (9') houses a conductive source region and the other between the implanted region (9') and the additional implanted region (9') houses a conductive drain region of the electronic device,
the method further comprising, before carrying out the oxidation step, the further step of removing the Silicon layer (56) with the exception of regions of the Silicon layer (56) extending between the implanted region (9') and the additional implanted region (9').

8. An electronic device (80; 100), comprising:
- a solid body (3, 2) of 4H-SiC having a first electrical conductivity (N);
- at least one region (9') having a second electrical conductivity (P) opposite to the first electrical conductivity (N) extending at a front side (2a) of the solid body (3, 2);
- a 3C-SiC layer (52) on the front side (2a);
- a Silicon layer (56) on the 3C-SiC layer (52);
- a Carbon-rich layer (58) on the Silicon layer (56), the Carbon-rich layer (58) being of graphite or including: Graphite, or one or more Graphite layers, or Graphene, or Graphite and Graphene;
- a ohmic contact region (84; 104) through the entire thickness of the 3C-SiC layer (52), the Silicon layer (56) and the Carbon-rich layer (58), up to reaching said region (9') having the second electrical conductivity; and
- a first electrical terminal (8) of conductive material above, and in direct contact with, the Carbon-rich layer (58).

9. The device according to claim 8, wherein the first electrical terminal (8) forms
a Schottky diode (87) with the Carbon-rich layer (58) and a junction-barrier diode (89) with the ohmic contact region (84).

10. The device according to claim 9, wherein the first electrical terminal (8) is common to said junction-barrier diode and Schottky diode, the electronic device further comprising, at a rear side (3b) opposite to the front side (2a) of the solid body, a second electrical terminal (7) common to said junction-barrier diode and Schottky diode.

11. The device according to claim 8, wherein said electronic device (80) is one of: a Merged-PiN-Schottky, MPS, device; a Junction Barrier Schottky, JBS, device; a MOSFET; an IGBT; a JFET; a DMOS.

## Patentansprüche

1. Verfahren zum Herstellen einer elektronischen Vorrichtung (50; 80), das die folgenden Schritte umfasst:
- Bilden, an einer Vorderseite (2a) eines Festkörpers (3, 2) aus 4H-SiC mit einer ersten elektrischen Leitfähigkeit (N), mindestens eines implantierten Bereichs (9'), der eine zweite elektrische Leitfähigkeit (P) aufweist, die der ersten elektrischen Leitfähigkeit (N) entgegengesetzt ist;
- Erhitzen, durch einen Laserstrahl, mindestens eines Abschnitts der Vorderseite (2a) des Festkörpers (3, 2) mindestens bis zu einer Schmelztemperatur des 4H-SiC-Materials;
- Ermöglichen der Kühlung und Kristallisation des geschmolzenen Abschnitts des Festkörpers (3, 2), Bilden eines Stapels übereinanderliegender Schichten, einschließlich: einer 3C-SiC-Schicht (52) in Kontakt mit dem Festkörper (3, 2), einer Siliziumschicht (56) auf der 3C-SiC-Schicht (52) und einer kohlenstoffreichen Schicht (58) auf der Siliziumschicht (56), wobei die kohlenstoffreiche Schicht (58) aus Graphit besteht oder Folgendes enthält: Graphit oder eine oder mehrere Graphitschichten oder Graphen oder Graphit und Graphen;
- Bilden eines ohmschen Kontaktbereichs (84; 104) durch den Stapel bis zum Erreichen des implantierten Bereichs (9'); und
- Bilden eines ersten elektrischen Anschlusses (8) aus leitfähigem Material oberhalb und in direktem Kontakt mit der kohlenstoffreichen Schicht (58).

2. Verfahren nach Anspruch 1, wobei der Schritt des Bildens des ersten elektrischen Anschlusses (8) das Aufbringen von metallischem Material oberhalb und in direktem Kontakt mit der kohlenstoffreichen Schicht (58) und dem ohmschen Kontaktbereich (84; 104) umfasst.

3. Verfahren nach Anspruch 1 oder 2, wobei das Bilden des ersten elektrischen Anschlusses (8) das gleichzeitige Bilden einer Schottky-Diode (57; 87) zwischen dem ersten elektrischen Anschluss (8) und der kohlenstoffreichen Schicht (58) und einer Sperrschichtdiode (59; 89) zwischen dem ersten elektrischen Anschluss (8) und dem ohmschen Kontaktbereich (54; 84) enthält.

4. Verfahren nach Anspruch 3, wobei der erste elektrische Anschluss (8) der Sperrschichtdiode und der Schottky-Diode gemeinsam ist,
wobei das Verfahren ferner den Schritt des Bildens, an einer Rückseite (3b) gegenüber der Vorderseite (2a) des Festkörpers, eines zweiten elektrischen Anschlusses (7) umfasst, der der Sperrschichtdiode und der Schottky-Diode gemeinsam ist.

5. Verfahren nach Anspruch 1, das ferner die folgenden Schritte umfasst:
- Entfernen selektiver Abschnitte der kohlenstoffreichen Schicht (58), die sich seitlich zum implantierten Bereich (9') erstrecken, wodurch jeweilige Abschnitte der darunterliegenden Siliziumschicht (56) freigelegt werden;
- Durchführen eines Oxidationsschritts der freiliegenden Abschnitte der Siliziumschicht (56), wodurch oxidierte Abschnitte (56') gebildet werden; und
- Bilden einer Metallisierung oberhalb und in Kontakt mit den oxidierten Abschnitten der Siliziumschicht (56).

6. Verfahren nach Anspruch 5, wobei die oxidierten Abschnitte (56') der Siliziumschicht (56) und die Metallisierung einen Gate-Anschluss der elektronischen Vorrichtung bilden.

7. Verfahren nach Anspruch 5 oder 6, ferner umfassend den Schritt des Bildens, an der Vorderseite (2a) des Festkörpers (3, 2), eines zusätzlichen implantierten Bereichs (9') mit der zweiten elektrischen Leitfähigkeit (P), wobei sich der zusätzliche implantierte Bereich (9') in einem Abstand vom implantierten Bereich (9') erstreckt, wobei sich die selektiven Abschnitte der kohlenstoffreichen Schicht (58), die entfernt werden, zwischen dem implantierten Bereich (9') und dem zusätzlichen implantierten Bereich (9') erstrecken,
und wobei einer zwischen dem implantierten Bereich (9') und dem zusätzlichen implantierten Bereich (9') einen leitfähigen Source-Bereich und der andere zwischen dem implantierten Bereich (9') und dem zusätzlichen implantierten Bereich (9') einen leitfähigen Drain-Bereich der elektronischen Vorrichtung aufnimmt,
wobei das Verfahren ferner vor dem Durchführen des Oxidationsschritts den weiteren Schritt des Entfernens der Siliziumschicht (56) mit Ausnahme von Bereichen der Siliziumschicht (56) umfasst, die sich zwischen dem implantierten Bereich (9') und dem zusätzlichen implantierten Bereich (9') erstrecken.

8. Elektronische Vorrichtung (80; 100), die Folgendes umfasst:
- einen Festkörper (3, 2) aus 4H-SiC mit einer ersten elektrischen Leitfähigkeit (N);
- mindestens einen Bereich (9'), der eine zweite elektrische Leitfähigkeit (P), die der ersten elektrischen Leitfähigkeit (N) entgegengesetzt ist und sich an einer Vorderseite (2a) des Festkörpers (3, 2) erstreckt;
- eine 3C-SiC-Schicht (52) auf der Vorderseite (2a);
- eine Siliziumschicht (56) auf der 3C-SiC-Schicht (52);
- eine kohlenstoffreiche Schicht (58) auf der Siliziumschicht (56), wobei die kohlenstoffreiche Schicht (58) aus Graphit besteht oder Folgendes enthält: Graphit oder eine oder mehrere Graphitschichten oder Graphen oder Graphit und Graphen;
- einen ohmschen Kontaktbereich (84; 104) durch die gesamte Dicke der 3C-SiC-Schicht (52), der Siliziumschicht (56) und der kohlenstoffreichen Schicht (58) bis zum Erreichen des Bereichs (9'), der die zweite elektrische Leitfähigkeit aufweist; und
- einen ersten elektrischen Anschluss (8) aus leitfähigem Material oberhalb und in direktem Kontakt mit der kohlenstoffreichen Schicht (58).

9. Vorrichtung nach Anspruch 8, wobei der erste elektrische Anschluss (8)
eine Schottky-Diode (87) mit der kohlenstoffreichen Schicht (58) und eine Sperrschichtdiode (89) mit dem ohmschen Kontaktbereich (84) bildet.

10. Vorrichtung nach Anspruch 9, wobei der erste elektrische Anschluss (8) gemeinsam mit der Sperrschichtdiode und der Schottky-Diode ist, wobei die elektronische Vorrichtung ferner an einer Rückseite (3b) gegenüber der Vorderseite (2a) des Festkörpers einen zweiten elektrischen Anschluss (7) umfasst, der der Sperrschichtdiode und der Schottky-Diode gemeinsam ist.

11. Vorrichtung nach Anspruch 8, wobei die elektronische Vorrichtung (80) eine der folgenden ist: eine Merged-PiN-Schottky-Vorrichtung (MPS); eine Sperrschicht-Schottky(JBS)-Vorrichtung; ein MOSFET; ein IGBT; ein JFET; ein DMOS.

## Revendications

1. Procédé de fabrication d'un dispositif électronique (50 ; 80), comprenant les étapes consistant à :
- former, sur un côté avant (2a) d'un corps solide (3, 2) en 4H-SiC ayant une première conductivité électrique (N), au moins une région implantée° (9') ayant une seconde conductivité électrique° (P) opposée à la première conductivité électrique° (N) ;
- chauffer, à travers un faisceau LASER, au moins une partie du côté avant° (2a) du corps solide° (3, 2), au moins jusqu'à une température de fusion du matériau 4H-SiC ;
- permettre le refroidissement et la cristallisation de la partie fondue du corps solide° (3, 2), formant un empilement de couches superposées comportant : une couche de 3C-SiC° (52) en contact avec le corps solide° (3, 2), une couche de silicone° (56) sur la couche de 3C-SiC° (52), et une couche riche en carbone° (58) sur la couche de silicone° (56), la couche riche en carbone° (58) étant en graphite ou comportant : du graphite, ou une ou plusieurs couches de graphite, ou du graphène, ou du graphite et du graphène ;
- former une région de contact ohmique° (84 ; 104) à travers ledit empilement, jusqu'à atteindre la région implantée° (9') ; et
- former une première borne électrique° (8) en matériau conducteur au-dessus, et en contact direct avec, la couche riche en carbone (58).

2. Procédé selon la revendication 1, dans lequel ladite étape de formation de la première borne électrique° (8) comporte le dépôt de matériau métallique au-dessus et en contact direct avec la couche riche en carbone° (58) et la région de contact ohmique° (84 ; 104).

3. Procédé selon la revendication 1 ou 2, dans lequel la formation de la première borne électrique° (8) comporte simultanément la formation d'une diode Schottky° (57 ; 87) entre la première borne électrique° (8) et la couche riche en carbone° (58), et d'une diode de barrière de jonction° (59 ; 89) entre la première borne électrique° (8) et la région de contact ohmique° (54 ; 84).

4. Procédé selon la revendication 3, dans lequel la première borne électrique° (8) est commune auxdites diode de barrière de jonction et diode Schottky,
le procédé comprenant en outre l'étape consistant à former, au niveau d'un côté arrière° (3b) opposé au côté avant° (2a) du corps solide, une seconde borne électrique° (7) commune auxdites diode de barrière de jonction et diode Schottky.

5. Procédé selon la revendication 1, comprenant en outre les étapes consistant à :
- éliminer des parties sélectives de la couche riche en carbone° (58) s'étendant latéralement à la région implantée° (9'), exposant des parties respectives de la couche de silicone° (56) sous-jacente ;
- réaliser une étape d'oxydation des parties exposées de la couche de silicone° (56), formant des parties oxydées° (56') ; et
- former une métallisation au-dessus, et en contact avec, des parties oxydées de la couche de silicone° (56).

6. Procédé selon la revendication 5, dans lequel lesdites parties oxydées° (56') de la couche de silicone° (56) et ladite métallisation forment une borne de grille du dispositif électronique.

7. Procédé selon la revendication 5 ou 6, comprenant en outre l'étape consistant à former, sur le côté avant° (2a) du corps solide° (3, 2), une région implantée supplémentaire° (9') ayant la seconde conductivité électrique° (P), ladite région implantée supplémentaire° (9') s'étendant à une distance de la région implantée° (9'),
dans lequel lesdites parties sélectives de la couche riche en carbone° (58) qui sont éliminées s'étendent entre la région implantée° (9') et la région implantée supplémentaire° (9'),
et dans lequel l'une entre la région implantée° (9') et la région implantée supplémentaire° (9') abrite une région source conductrice et l'autre entre la région implantée° (9') et la région implantée supplémentaire° (9') abrite une région drain conductrice du dispositif électronique,
le procédé comprenant en outre, avant de réaliser l'étape d'oxydation, l'étape supplémentaire consistant à éliminer la couche de silicone° (56) à l'exception de régions de la couche de silicone° (56) s'étendant entre la région implantée° (9') et la région implantée supplémentaire° (9').

8. Dispositif électronique° (80 ; 100), comprenant :
- un corps solide° (3, 2) en 4H-SiC ayant une première conductivité électrique°(N) ;
- au moins une région° (9') ayant une seconde conductivité électrique° (P) opposée à la première conductivité électrique° (N) s'étendant au niveau d'un côté avant° (2a) du corps solide° (3, 2) ;
- une couche de 3C-SiC° (52) sur le côté avant° (2a) ;
- une couche de silicone° (56) sur la couche de 3C-SiC° (52) ;
- une couche riche en carbone° (58) sur la couche de silicone° (56), la couche riche en carbone° (58) étant en graphite ou comportant : du graphite, ou une ou plusieurs couches de graphite, ou du graphène, ou du graphite et du graphène ;
- une région de contact ohmique° (84 ; 104) à travers toute l'épaisseur de la couche de 3C-SiC° (52), de la couche de silicone° (56) et de la couche riche en carbone° (58), jusqu'à atteindre ladite région° (9') ayant la seconde conductivité électrique ; et
- une première borne électrique° (8) en matériau conducteur au-dessus, et en contact direct avec, la couche riche en carbone° (58) .

9. Dispositif selon la revendication 8, dans lequel la première borne électrique° (8) forme
une diode Schottky° (87) avec la couche riche en carbone° (58) et une diode de barrière de jonction° (89) avec la région de contact ohmique° (84) .

10. Dispositif selon la revendication 9, dans lequel la première borne électrique° (8) est commune auxdites diode barrière de jonction et diode Schottky, le dispositif électronique comprenant en outre, au niveau d'un côté arrière° (3b) opposé au côté avant° (2a) du corps solide, une seconde borne électrique° (7) commune auxdites diode de barrière de jonction et diode Schottky.

11. Dispositif selon la revendication 8, dans lequel ledit dispositif électronique°(80) est l'un parmi : un dispositif Merged-PiN-Schottky, MPS ; un dispositif Junction Barrier Schottky, JBS ; un MOSFET ; un IGBT ; un JFET ; un DMOS.
